# EUROPEAN PATENT SPECIFICATION

(11) **EP 4 471 843 B1**
(45) Date of publication and mention of the grant of the patent: **09.07.2025**
(21) Application number: 23176123.0
(22) Date of filing: 30.05.2023
(51) Int. Cl.: H01L 23/051, H01L 23/00

(54) **SEMICONDUCTOR SWITCHING DEVICE WITH PRESSURE SYSTEM**
HALBLEITERSCHALTVORRICHTUNG MIT DRUCKSYSTEM
DISPOSITIF DE COMMUTATION À SEMI-CONDUCTEUR AVEC SYSTÈME DE PRESSION

(43) Date of publication of application: 04.12.2024
(73) Proprietor: Hitachi Energy Ltd, 8050 Zürich (CH)
(72) Inventor: TILSER, Michal, 170 00 Prague (CZ)
(74) Representative: Epping - Hermann - Fischer

(56) References cited:
- US-A- 5 777 351
- US-B2- 10 249 747
- US-B2- 9 698 067

## Description

The present disclosure relates to a semiconductor switching device and a method for assembling a semiconductor switching device. The device may be a Gate Commutated Thyristor (GCT), in particular an Integrated Gate Commutated Thyristor (IGCT). Increasing ratings of maximal controllable turn-off current requested from IGCTs result in an increasing size of IGCT wafers from about 100 to 150 mm diameter. Thereby, also the housing increases, leading to higher complexity and costs. In addition to that, a simple mounting of large-area devices has to be enabled. Furthermore, all parts inside a housing have to be properly aligned and supported already during transport to ensure proper contacting after transport.

Document US 9,698,067 B2 discloses a spacer system for a semiconductor switching device which is formed as a spacer ring and a plurality of insulating elements. Document US 10,892,245 B2 discloses a switching device comprising a semiconductor element and a housing comprising a spring system with a ring-shaped washer laterally surrounding the semiconductor element for clamping the semiconductor element between two pole pieces.

Embodiments of the disclosure relate to an improved semiconductor switching device.

The invention is set out in the appended set of claims.

According to a first aspect of the disclosure a semiconductor switching device comprises a gate ring and a gate connector element for contacting the gate ring and comprises a pressure system for pressing the gate connector element onto the gate ring. The pressure system comprises an insulating ring and a plurality of spring beams arranged circumferentially on the insulating ring, wherein the insulating ring comprises a plurality of supports for supporting ends of the spring beams.

As examples, the semiconductor switching device may be a Gate Commutated Thyristor (GCT) or a Gate Turn-off Thyristor (GTO). The semiconductor switching device may be an Integrated Gate Commutated Thyristor (IGCT).

Semiconductor switching devices are often transported to a customer as a single piece and a plurality of devices may be stacked by the customer. In the stack, each of the devices is clamped. The pressure system presses the gate connector element onto the gate ring in the clamped state.

The gate connector element may comprise a plurality of fingers. Each of the fingers may rest on one of the spring beams. The fingers may rest on a central section of the spring beam. The fingers may be partly bend around the spring beams.

For preventing a movement of the spring beams in a circumferential direction, a wall may be present between adjacent ones of the supports. Thereby, the spring beams can be kept in alignment with fingers of the gate connector element.

The spring beams may comprise a thickening in their central sections. Accordingly, the spring beams may be thicker in their central sections than at their ends. The thickening may protrude axially beyond the supports. Thereby, a clearance between the gate ring and the supports can be enlarged. In addition to that, a clearance between the cathode pole piece and the semiconductor substrate can be ensured during a non-clamped state of the device.

The insulating ring may comprise a plurality of pins at a second side of the insulating ring opposite to a first side where the spring beams are arranged, wherein the plurality of pins are configured to provide a rotational locking of the insulating ring and/or further parts of the semiconductor switching device. As an example, a rotational locking of the gate connector element may be achieved.

The switching device may comprise a spacer ring for insulating the gate connector element from a cathode pole piece. The pressure system may provide a rotational locking of the spacer ring. The spacer ring may comprise a plurality of support elements for supporting the gate connector element and a plurality of slots between the support elements, wherein the pins engage in the slots. Accordingly, a rotational locking can be achieved by simply inserting the pins in the slots.

Each of the support elements may comprise a first portion and a second portion. The gate connector element may rest on the first portion and be prevented from rotating in one rotational direction by the second portion. The first and second portion may be provided as steps.

The pressure system is configured to be provided as a single piece for assembly of the semiconductor switching device. Accordingly, the spring beams are securely fixed to the insulating ring by the supports of the pressure system. This enables a fast and simply assembly and disassembly of the device.

According to a further aspect of the disclosure, a method for assembling a semiconductor switching device comprises the steps of providing a housing assembly of the semiconductor switching device and providing a pressure system for pressing a gate connector element onto a gate ring of the switching device. The housing assembly comprises a housing, a gate connector element and a cathode pole piece. The pressure system comprises an insulating ring and a plurality of spring beams arranged circumferentially on the insulating ring, wherein the insulating ring comprises a plurality of supports for supporting ends of the spring beams. In the method, the pressure system is assembled with the housing assembly, wherein the pressure system is provided as a single piece. The semiconductor switching device assembled in this method may have any structural and functional characteristics of the device described in the foregoing.

By providing the pressure system in the form of a single piece the assembly can be simplified. Thereby costs can be reduced and a correct assembly can be easily ensured when compared to a pressure system where single parts are provided and the parts are separately assembled with parts of the device.

Before assembling the pressure system with the housing assembly, a spacer ring for insulating the gate connector element from the cathode pole piece may be provided. The spacer ring comprises a plurality of support elements, wherein the spacer ring is placed around the cathode pole piece and rotated until the gate connector element is positioned on the support elements of the spacer ring.

In particular, fingers of the gate connector element may be positioned on first support portions of the support element and a further rotation of the spacer ring is blocked by second portions of the support element.

When assembling the pressure system, pins of the pressure system may be inserted in slots of the spacer ring. Thereby, a simple and effective self-locking mechanism of the pressure system and the spacer ring may be achieved.

After assembly of the pressure system, fingers of the gate connector element may be bend to be positioned on the spring beams.

The present disclosure comprises several aspects and embodiments. Every feature described with respect to one of the aspects and embodiments is also disclosed herein with respect to the other aspects and embodiments, even if the respective feature is not explicitly mentioned in this context.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
- Figure 1: shows in a cross-sectional view a detail of a switching device to an embodiment,
- Figure 2A: is a perspective view of a pressure system of the switching device of Figure 1,
- Figure 2B: shows a detail of Figure 2A,
- Figure 2C: shows a details of Figure 2B,
- Figure 3: shows the switching device of Figure 1 in a clamped state,
- Figure 4A: shows a perspective view of a spacer ring of a switching device according to an embodiment,
- Figure 4B: shows an enlarged detail of Figure 4A,
- Figures 5A and 5B: show in a perspective view steps in a method for assembling a switching device according to an embodiment,
- Figure 6A: shows a cross-sectional view of a detail of a switching device according to a further embodiment,
- Figure 6B: shows a perspective view of a pressure system in the switching device of Figure 6A.

All embodiments fall within the scope of the claimed invention.

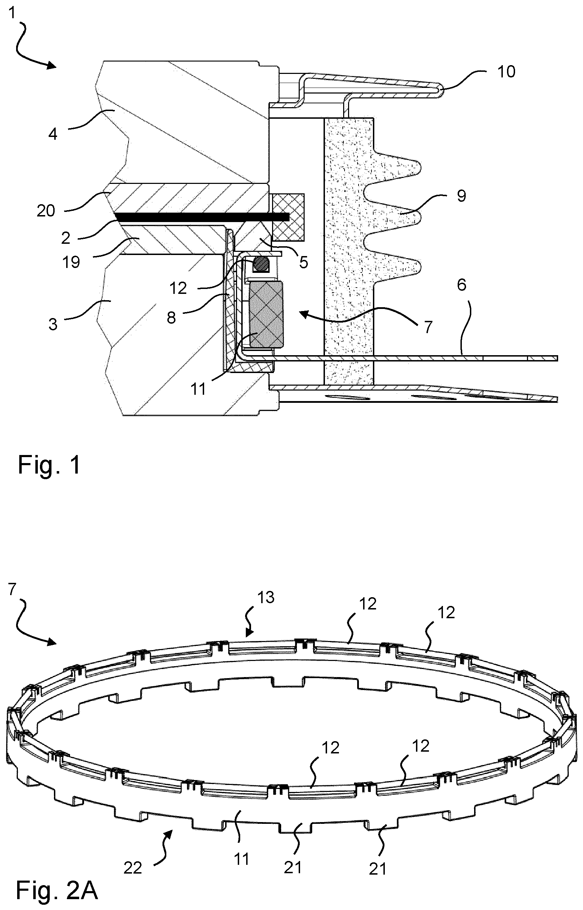

Figure 1 shows a detail of a semiconductor switching device 1. The switching device 1 may be a GCT (Gate-Commutated Thyristor), in particular an IGCT (Integrated Gate-Commutated Thyristor). The IGCT may be a large-area IGCT, where the gate structure on the GCT wafer is placed on wafer periphery.

The switching device 1 comprises a semiconductor substrate 2, a cathode pole piece 3, an anode pole piece 4 and gate ring 5. The cathode pole piece 3 comprises a cathode strain buffer plate 19 and the anode pole piece 4 comprises an anode strain buffer plate 20. The strain buffer plates 19, 20 are made of an electrically conductive material having a coefficient of thermal expansion which is between that of the semiconductor substrate 2 and the respective pole piece 3, 4. The gate ring 5 is electrically connected by a gate connector element 6.

A pressure system 7 serves to apply a required pressure force on the gate connector element 6. The gate connector element 6 transfers the force on the gate ring 5 to ensure proper switching capability of the semiconductor substrate 2.

In addition to that, the pressure system 7 serves to lock elements in place, e.g. during transport or during vibrations tests. The pressure system 7 locks a spacer ring 8 and prevents it from turning around. The spacer ring 8 electrically insulates the gate connector element 6 from the cathode pole piece 3.

The switching device 1 comprises a housing 9 comprising creepage sections at the outside. The housing 9 is connected to the anode pole piece 4 by an anode flange 10.

During transport and vibration tests, the switching device 1 is usually provided as a single piece. In operation, a stack of clamped switching devices 1 can be formed for electrically interconnecting the switching devices 1. In the stack, the anode pole piece 4 is pressed towards the semiconductor substrate 2.

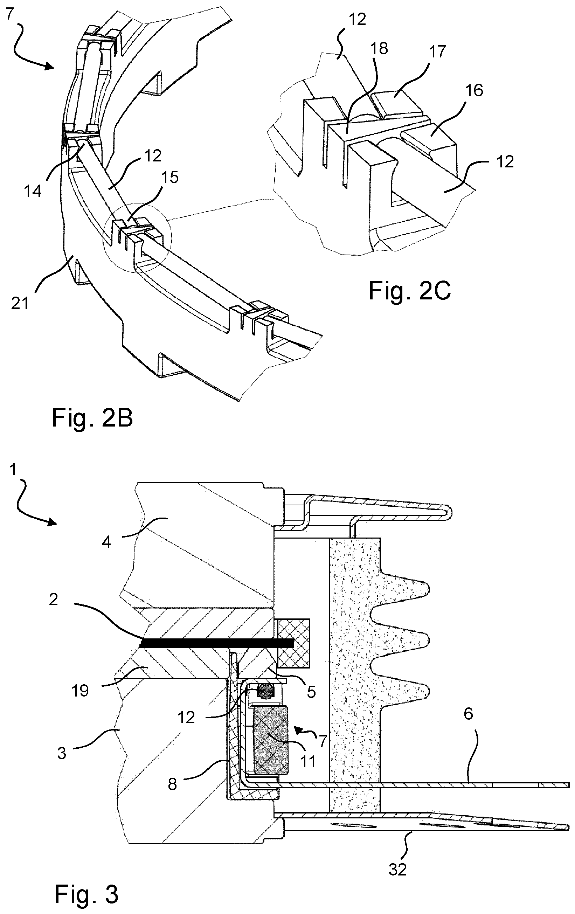

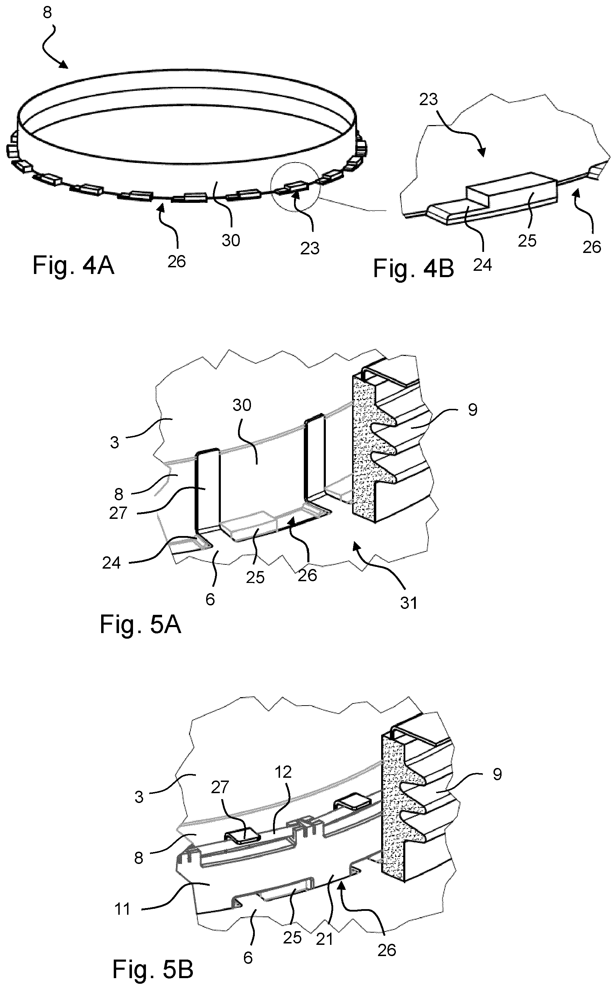

Figure 2A shows the pressure system 7 which is part of the switching device 1 of Figure 1 and is assembled with a housing assembly when forming the switching device 1 (see Fig. 5A). Figure 2B shows an enlarged detail of Figure 2B and Figure 2C shows an enlarged detail of Figure 2B.

The pressure system 7 comprises an insulating ring 11 of an insulating material. The insulating ring 11 may comprise a plastic material, for example.

The pressure system 7 further comprises a plurality of spring beams 12. The pressure system 7 consists of the insulating ring 11 and the plurality of spring beams 12. The spring beams 12 are configured to deflect and return to their original shape afterwards. The spring beams 12 may comprise a spring material such as spring steel. The pressure system 7 can be denoted as "segmented" pressure system 7 due to the plurality of spring beans 12 instead of a single spring extending circumferentially along the insulating ring 11.

The spring beams 12 are mounted on a first side 13 of the insulating ring 11. The first side 13 can be denoted as top side. The spring beams 12 are arranged circumferentially along the first side 13 and form a closed ring. Each of the spring beams 12 is fixed at each of its ends 14, 15 in one of a plurality of supports 16, 17. The supports 16, 17 may be an integral part of the insulating ring 11. The spring beams 12 may be held into the supports 16, 17. The supports 16, 17 have a flexible self-locking design such that the spring beams 12 are securely fixed to the ring 2. As an example, the spring beams 12 can be clicked into the supports 16, 17.

A wall 18 between adjacent supports 16, 17 provides positioning of the spring beams 12 in the correct circumferential position. This ensures that the spring beams 12 are centered with respect to a gate connector element 6 to ensure correct pressure distribution.

Due to the segmented design of the insulating ring 11, a tuning of the pressure force on the gate ring 5 can be easily adjusted by changing the length, diameter or the total number of the spring beams 12. Furthermore, the segmented design enables reducing the total height of the pressure system 7, which allows to reduce the total height of the housing 9 of the switching device 1. This may allow to reduce the total height particularly in case of designs for lower voltage classes.

The pressure system 7 comprises pins 21 at a second side 22 of the insulating ring 11. The second side 22 is a side opposite to the first side 13 and may be a bottom side of the insulating ring 11. The pins 21 serve to hold further part of the switching device 1 in place as will be explained in detail in connection with Figures 5A and 5B. The pins 21 may be an integral part of the insulating ring 11.

Figure 3 shows the switching device 1 of Figure 1 in a clamped state. As distinguished from the non-clamped state as shown in Figure 1, the anode pole piece 4 is pressed towards the semiconductor substrate 2. The gap between the cathode strain buffer plate 19 and the semiconductor substrate 2 is removed.

In addition to that, the spring beams 12 are deflected downwards in their central sections and, thus strained.

Accordingly, the spring beams 12 exert a spring force onto the gate connector element 6 towards the gate ring 5. In the non-clamped state as shown in Figure 1, the sprig beams 12 are relaxed. It is also possible that the spring beans 12 are already slightly deflected and, thus, strained in the non-clamped state. It is also possible that the pressure system slightly presses the gate connector element onto the gate ring already in the non-clamped state of the device.

Figure 4A shows a perspective view of the spacer ring 8 and Figure 4B shows a detail thereof. The spacer ring 8 comprises a ring-shaped wall 30 and a plurality of support elements 23 arranged circumferentially at a bottom side of the wall 30.

Each of the support elements 23 comprises a first portion 24 and a second portion 25, wherein the first portion 24 has a smaller height than the second portion 25. The first portion 24 is provided for supporting the gate connector element 6, in particular fingers 27 of the gate connector element 6 (see also Figure 5A).

The second portion 25 is configured to from a stop for the fingers 27 when assembling the switching device 1 (see also Figure 5A). The second portion 25 may additionally form a support for the pressure system 7.

The slots 26 are configured to receive the pins 21 of the pressure system 7 (see Figure 5B).

Figures 5A and 5B shows steps in a method for assembling a switching device 1. The switching device 1 and the components thereof may be as described in connection with the foregoing figures.

In Figure 5A, a housing assembly 31 of the switching device 1 including the housing 9, the cathode pole piece 3 and the gate connector element 6 is provided. The gate connector element 6 is fixed to the housing 9, as an example soldered between two parts of the housing 9. The housing assembly 31 comprises also a further gate connector element 32 (see Fig. 3) fixed to the housing 9 and fixed to the cathode pole piece 3.

A spacer ring 8 is inserted into the housing assembly 31 from the top. The slots 26 are initially aligned with the fingers 27 of the gate connector element 6. Once the spacer ring 8 sits on the cathode pole piece 3, the spacer ring 8 is rotated until the fingers 27 sit on the first portions 24 of the support element 23. The rotation is stopped by abutment of the fingers 27 on the left side of the second portion 25. The rotation is clockwise when seen from a top to a bottom of the housing 9. Figure 5A shows the fingers 27 in their end position after rotation.

Figure 5B shows a subsequent step, in which the pressure system 7 is inserted into the housing 9 from a top side such that the pins 21 fit into the slots 26. The pressure system 7 is inserted as a single pre-assembled piece. The pressure system 7 may then sit on the second portion 25 of the support element 23 and/or directly on the cathode pole piece 3.

In this position, the pressure system 7 prevents the fingers 27 from moving back anti-clockwise. The spacer ring 8, the pressure system 7 and the fingers 27 are locked together and prevented from rotation. Accordingly, a self-locking design of pressure system 7, gate connector element 6 and spacer ring 8 is provided.

Moreover, due to the pins 21, which fit properly into the slots 26, the spring beams 12 are also properly aligned with the fingers 27. In a subsequent step, the fingers 27 are bend over the spring beams 12. The fingers 27 are aligned with a central section of the beams 12 so that the pressure onto the gate ring 5 can be distributed homogeneously.

After that, the gate ring 5, the semiconductor substrate 2 and the anode pole piece 4 is inserted in the housing 9 from the top side and the anode flange 10 is fixed to the anode pole piece 4.

The rotational locking by inserting the pins 21 in the slots 26 is simple and does not require special tools. Accordingly, the assembly is simpler and faster than in the prior art where fingers 27 are bend into a specific position of a spacer ring for preventing the spacer ring from rotation.

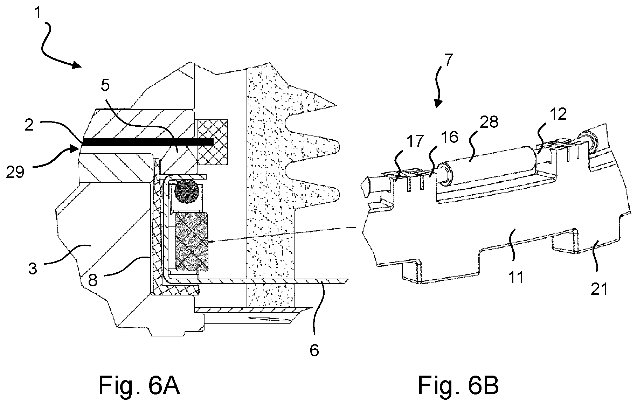

Figures 6A and 6B show a further embodiment of a semiconductor switching device 1 with a pressure system 7. The only distinguishing feature from the embodiments described in the foregoing is that the spring beams 12 have a thickening 28 in a central section. The thickening 28 may be an integral part with the rest of the spring beam 12. It is also possible that the thickening 28 is an additional element enclosing the rest of the spring beam 12.

Due to the thickening 28 the spring beam 12 protrudes in an axial direction beyond the supports 16, 17.

Thereby, a clearance 29 between the cathode pole piece 3 and the semiconductor substrate 2 can be enlarged. Furthermore, it is ensured that a proper distance between the supports 16, 17 and the gate ring 5 is maintained. The thickening 28 also enables a larger bending of the spring beams 12 without that the gate ring 5 sits on the supports 16, 17.

Overall, the segmented pressure system 7 makes the assembly of the switching device 1 easier, faster and poka-yoke, because the pressure system 7 can be inserted in the housing 9 as a pre-assembled part. This is an advantage over the prior art where several disc springs and spring washers have to be individually inserted into the housing 9 during assembly of a GCT element, and each of the elements has to be correctly oriented.

In addition to that, the segmented pressure system 7 can be made more compact in terms of total height. Thereby, also the housing 9 can have a smaller height and cost saving, as long as it is sufficient for the desired voltage class.

A fine tuning of the spring characteristics of the pressure system 7 can be achieved by adjusting the number, diameters or lengths of the spring beams 12 to achieve the required pressure force applied on the gate ring 5.

Due to the simple design of the spring beams 12, being basically a beam supported at both ends, the spring characteristics can be easily calculated at first iteration from the basic principles of mechanics. Suitable spring beams 12 are available on the market in various material options and dimensions and are cheaper than disc springs and spring washers of existing pressure systems. Due to the simplicity of the design, the pressure system 7 can easily be tested, e.g. in 3D printing, before implementing the design in the production. Furthermore, when the pressure system 7 comprises only two pieces in stack, i.e. the insulating ring 11 and a spring beam 12, the requirements on the accuracy of total thickness and clearances are lower than for existing concepts with more pieces, i.e. two washers and two disc springs, in stack.

### Reference Signs

- 1: semiconductor switching device
- 2: semiconductor substrate
- 3: cathode pole piece
- 4: anode pole piece
- 5: gate ring
- 6: gate connector element
- 7: pressure system
- 8: spacer ring
- 9: housing
- 10: anode flange
- 11: insulating ring
- 12: spring beam
- 13: first side
- 14: end
- 15: end
- 16: support
- 17: support
- 18: wall between supports
- 19: cathode strain buffer plate
- 20: cathode strain buffer plate
- 21: pin
- 22: second side
- 23: support element
- 24: first portion
- 25: second portion
- 26: slot
- 27: finger
- 28: thickening
- 29: clearance
- 30: wall of spacer ring
- 31: housing assembly
- 32: further gate connector element

## Claims

1. A semiconductor switching device (1) comprising a gate ring (5) and a gate connector element (6) for contacting the gate ring (5) and comprising a pressure system (7) for pressing the gate connector element (6) onto the gate ring (5), **characterized in that** the pressure system (7) comprises an insulating ring (11) and a plurality of spring beams (12) arranged circumferentially on the insulating ring (11), wherein the insulating ring (11) comprises a plurality of supports (16, 17) for supporting ends (14, 15) of the spring beams (12).

2. The semiconductor switching device (1) of claim 1, wherein the gate connector element (6) comprises a plurality of fingers (27), wherein each of the fingers (27) rests on one of the spring beams (12).

3. The semiconductor switching device (1) of any of the preceding claims, comprising a wall (18) between adjacent ones of the supports (16, 17) for preventing a movement of the spring beams (12) in a circumferential direction.

4. The semiconductor switching device (1) of any of the preceding claims, wherein the spring beams (12) comprise a thickening (28) in a central section.

5. The semiconductor switching device (1) of any of the preceding claims, wherein the insulating ring (11) comprises a plurality of pins (21) at a second side (22) of the insulating ring (11) opposite to a first side (13) where the spring beams (12) are arranged, wherein the plurality of pins (21) are configured to provide a rotational locking of the pressure system (7) and/or further parts of the semiconductor switching device (1).

6. The semiconductor switching device (1) of claim 5, comprising a spacer ring (8) for insulating the gate connector element (6) from a cathode pole piece (3), wherein the pressure system (7) provides a rotational locking of the spacer ring (8).

7. The semiconductor switching device (1) of claim 6, wherein the spacer ring (8) comprises a plurality of support elements (23) for supporting the gate connector element (6) and a plurality of slots (26) between the support elements (23), wherein the pins (21) engage in the slots (26).

8. The semiconductor switching device (1) of claim 7, wherein each of the support elements (23) comprises a first portion (24) and a second portion (25), wherein the gate connector element (6) rests on the first portion (24) and is prevented from rotating in one rotational direction by the second portion (25).

9. The semiconductor switching device (1) of any of the preceding claims, in which the pressure system (7) is configured to be provided as a single piece for assembly of the semiconductor switching device (1).

10. The semiconductor switching device (1) of any of the preceding claims, the switching device (1) being selected from a gate commutated thyristor, an integrated gate commutated thyristor and a gate turn-off thyristor.

11. A method for assembling a semiconductor switching device (1) comprising a gate ring (5), the method comprising the steps of:
A) providing a housing assembly (31) of the semiconductor switching device (1) comprising a housing (9), a gate connector element (6) and a cathode pole piece (3), providing a pressure system (7) for pressing the gate connector element (6) onto the gate ring (5), **characterized in that** the pressure system (7) comprises an insulating ring (11) and a plurality of spring beams (12) arranged circumferentially on the insulating ring (11), wherein the insulating ring (11) comprises a plurality of supports (16, 17) for supporting ends (14, 15) of the spring beams (12),
B) assembling the pressure system (7) with the housing assembly (31), wherein the pressure system (7) is provided as a single piece.

12. The method of claim 11,
wherein before step B) a spacer ring (8) for insulating the gate connector element (6) from the cathode pole piece (3) is provided, the spacer ring (8) comprising a plurality of support elements (23), wherein the spacer ring (8) is placed around the cathode pole piece (3) and rotated until the gate connector element (6) is positioned on a support element (23) of the spacer ring (8).

13. The method of claim 12,
wherein the gate connector element (6) comprises a plurality of fingers (7) and the support element (23) comprises a first portion (24) and a second portion (25), wherein the spacer ring (8) is rotated until the fingers (7) are positioned on the first portions (24) and a further rotation is blocked by the second portion (25).

14. The method of claim 13,
wherein assembling the pressure system (7) comprises inserting pins (21) of the pressure system (7) into slots (26) of the spacer ring (8).

15. The method of any of claims 11 to 14,
wherein the gate connector element (6) comprises a plurality of fingers (27), wherein the fingers (27) are bend to be positioned on the spring beams (12).

## Patentansprüche

1. Halbleiterschaltvorrichtung (1), die einen Gate-Ring (5) und ein Gate-Anschlusselement (6) zum Kontaktieren des Gate-Rings (5) umfasst und ein Drucksystem (7) zum Drücken des Gate-Anschlusselements (6) auf den Gate-Ring (5) umfasst, **dadurch gekennzeichnet, dass** das Drucksystem (7) einen Isolationsring (11) und mehrere umlaufend auf dem Isolationsring (11) angeordnete Federträger (12) umfasst, wobei der Isolationsring (11) mehrere Halterungen (16, 17) zum Halten von Enden (14, 15) der Federträger (12) umfasst.

2. Halbleiterschaltvorrichtung (1) nach Anspruch 1, wobei das Gate-Anschlusselement (6) mehrere Finger (27) umfasst, wobei jeder der Finger (27) auf einem der Federträger (12) ruht.

3. Halbleiterschaltvorrichtung (1) nach einem der vorhergehenden Ansprüche, umfassend eine Wand (18) zwischen benachbarten der Halterungen (16, 17) zum Verhindern einer Bewegung der Federträger (12) in einer Umfangsrichtung.

4. Halbleiterschaltvorrichtung (1) nach einem der vorhergehenden Ansprüche, wobei die Federträger (12) eine Verdickung (28) in einem zentralen Abschnitt umfassen.

5. Halbleiterschaltvorrichtung (1) nach einem der vorhergehenden Ansprüche, wobei der Isolationsring (11) mehrere Stifte (21) an einer zweiten Seite (22) des Isolationsrings (11) gegenüber einer ersten Seite (13), an der die Federträger (12) angeordnet sind, umfasst, wobei die mehreren Stifte (21) dazu ausgelegt sind, eine Drehverriegelung des Drucksystems (7) und/oder weiterer Teile der Halbleiterschaltvorrichtung (1) bereitzustellen.

6. Halbleiterschaltvorrichtung (1) nach Anspruch 5, umfassend einen Abstandhalterring (8) zum Isolieren des Gate-Anschlusselements (6) von einem Kathodenpolstück (3), wobei das Drucksystem (7) eine Drehverriegelung des Abstandhalterrings (8) bereitstellt.

7. Halbleiterschaltvorrichtung (1) nach Anspruch 6, wobei der Abstandhalterring (8) mehrere Halteelemente (23) zum Halten des Gate-Anschlusselements (6) und mehrere Schlitze (26) zwischen den Halteelementen (23) umfasst, wobei die Stifte (21) in die Schlitze (26) eingreifen.

8. Halbleiterschaltvorrichtung (1) nach Anspruch 7, wobei jedes der Halteelemente (23) einen ersten Abschnitt (24) und einen zweiten Abschnitt (25) umfasst, wobei das Gate-Anschlusselement (6) auf dem ersten Abschnitt (24) ruht und durch den zweiten Abschnitt (25) daran gehindert wird, sich in einer Drehrichtung zu drehen.

9. Halbleiterschaltvorrichtung (1) nach einem der vorhergehenden Ansprüche, wobei das Drucksystem (7) dazu ausgelegt ist, einstückig zur Montage der Halbleiterschaltvorrichtung (1) bereitgestellt zu werden.

10. Halbleiterschaltvorrichtung (1) nach einem der vorhergehenden Ansprüche, wobei die Schaltvorrichtung (1) aus einem Gate-kommutierten Thyristor, einem integrierten Gate-kommutierten Thyristor und einem Gate-Abschaltthyristor ausgewählt ist.

11. Verfahren zum Montieren einer Halbleiterschaltvorrichtung (1), die einen Gate-Ring (5) umfasst, wobei das Verfahren die folgenden Schritte umfasst:
A) Bereitstellen einer Gehäuseanordnung (31) der Halbleiterschaltvorrichtung (1), die ein Gehäuse (9), ein Gate-Anschlusselement (6) und ein Kathodenpolstück (3) umfasst, Bereitstellen eines Drucksystems (7) zum Drücken des Gate-Anschlusselements (6) auf den Gate-Ring (5), **dadurch gekennzeichnet, dass** das Drucksystem (7) einen Isolationsring (11) und mehrere umlaufend auf dem Isolationsring (11) angeordnete Federträger (12) umfasst, wobei der Isolationsring (11) mehrere Halterungen (16, 17) zum Halten von Enden (14, 15) der Federträger (12) umfasst,
B) Montieren des Drucksystems (7) mit der Gehäuseanordnung (31), wobei das Drucksystem (7) einstückig bereitgestellt wird.

12. Verfahren nach Anspruch 11,
wobei vor Schritt B) ein Abstandhalterring (8) zum Isolieren des Gate-Anschlusselements (6) von dem Kathodenpolstück (3) bereitgestellt wird, wobei der Abstandhalterring (8) mehrere Halteelemente (23) umfasst, wobei der Abstandhalterring (8) um das Kathodenpolstück (3) herum platziert und gedreht wird, bis das Gate-Anschlusselement (6) auf einem Halteelement (23) des Abstandhalterrings (8) positioniert ist.

13. Verfahren nach Anspruch 12,
wobei das Gate-Anschlusselement (6) mehrere Finger (7) umfasst und das Halteelement (23) einen ersten Abschnitt (24) und einen zweiten Abschnitt (25) umfasst, wobei der Abstandhalterring (8) gedreht wird, bis die Finger (7) auf den ersten Abschnitten (24) positioniert sind und eine weitere Drehung durch den zweiten Abschnitt (25) blockiert wird.

14. Verfahren nach Anspruch 13,
wobei das Montieren des Drucksystems (7) Einsetzen von Stiften (21) des Drucksystems (7) in Schlitze (26) des Abstandhalterrings (8) umfasst.

15. Verfahren nach einem der Ansprüche 11 bis 14,
wobei das Gate-Anschlusselement (6) mehrere Finger (27) umfasst, wobei die Finger (27) gebogen werden, um auf den Federträgern (12) positioniert zu werden.

## Revendications

1. Dispositif de commutation à semi-conducteurs (1) comprenant une bague faisant grille (5) et un élément de connexion de grille (6) destiné à entrer en contact avec la bague faisant grille (5) et comprenant un système de pression (7) destiné à appuyer l'élément de connexion de grille (6) sur la bague faisant grille (5), **caractérisé en ce que** le système de pression (7) comprend une bague isolante (11) et une pluralité de tiges faisant ressort (12) disposées circonférentiellement sur la bague isolante (11), dans lequel la bague isolante (11) comprend une pluralité de supports (16, 17) destinés à soutenir des extrémités (14, 15) des tiges faisant ressort (12).

2. Dispositif de commutation à semi-conducteurs (1) selon la revendication 1, dans lequel l'élément de connexion de grille (6) comprend une pluralité de doigts (27), dans lequel chacun des doigts (27) repose sur une des tiges faisant ressort (12).

3. Dispositif de commutation à semi-conducteurs (1) selon l'une quelconque des revendications précédentes, comprenant une paroi (18) entre supports adjacents (16, 17) destinée à empêcher un mouvement des tiges faisant ressort (12) dans une direction circonférentielle.

4. Dispositif de commutation à semi-conducteurs (1) selon l'une quelconque des revendications précédentes, dans lequel les tiges faisant ressort (12) présentent un épaississement (28) dans une section centrale.

5. Dispositif de commutation à semi-conducteurs (1) selon l'une quelconque des revendications précédentes, dans lequel la bague isolante (11) comprend une pluralité de broches (21) sur un deuxième côté (22) de la bague isolante (11) à l'opposé d'un premier côté (13) sur lequel sont disposées les tiges faisant ressort (12), dans lequel la pluralité de broches (21) sont conçues pour assurer un verrouillage en rotation du système de pression (7) et/ou d'autres pièces du dispositif de commutation à semi-conducteurs (1).

6. Dispositif de commutation à semi-conducteurs (1) selon la revendication 5, comprenant une bague-entretoise (8) destinée à isoler l'élément de connexion de grille (6) d'une pièce polaire cathodique (3), dans lequel le système de pression (7) assure un verrouillage en rotation de la bague-entretoise (8).

7. Dispositif de commutation à semi-conducteurs (1) selon la revendication 6, dans lequel la bague-entretoise (8) comprend une pluralité d'éléments de support (23) destinés à soutenir l'élément de connexion de grille (6) et une pluralité de fentes (26) entre les éléments de support (23), dans lequel les broches (21) s'enclenchent dans les fentes (26).

8. Dispositif de commutation à semi-conducteurs (1) selon la revendication 7, dans lequel chacun des éléments de support (23) comprend une première partie (24) et une deuxième partie (25), dans lequel l'élément de connexion de grille (6) repose sur la première partie (24) et la deuxième partie (25) l'empêche de tourner dans une direction de rotation.

9. Dispositif de commutation à semi-conducteurs (1) selon l'une quelconque des revendications précédentes, dans lequel le système de pression (7) est conçu pour être obtenu sous la forme d'une seule pièce pour l'assemblage du dispositif de commutation à semi-conducteurs (1).

10. Dispositif de commutation à semi-conducteurs (1) selon l'une quelconque des revendications précédentes, le dispositif de commutation (1) étant choisi parmi un thyristor à commutation de grille, un thyristor à commutation de grille intégré et un thyristor à coupure de grille.

11. Procédé d'assemblage d'un dispositif de commutation à semi-conducteurs (1) comprenant une bague faisant grille (5), le procédé comprenant les étapes suivantes :
A) obtention d'un ensemble boîtier (31) du dispositif de commutation à semi-conducteurs (1) comprenant un boîtier (9), un élément de connexion de grille (6) et une pièce polaire cathodique (3), obtention d'un système de pression (7) destiné à appuyer l'élément de connexion de grille (6) sur la bague faisant grille (5), **caractérisé en ce que** le système de pression (7) comprend une bague isolante (11) et une pluralité de tiges faisant ressort (12) disposées circonférentiellement sur la bague isolante (11), dans lequel la bague isolante (11) comprend une pluralité de supports (16, 17) destinés à soutenir des extrémités (14, 15) des tiges faisant ressort (12),
B) assemblage du système de pression (7) avec l'ensemble boîtier (31), dans lequel le système de pression (7) est obtenu sous la forme d'une seule pièce.

12. Procédé selon la revendication 11,
dans lequel, avant l'étape B), une bague-entretoise (8) destinée à isoler l'élément de connexion de grille (6) de la pièce polaire cathodique (3) est obtenue, la bague-entretoise (8) comprenant une pluralité d'éléments de support (23), dans lequel la bague-entretoise (8) est placée autour de la pièce polaire cathodique (3) et tournée jusqu'à ce que l'élément de connexion de grille (6) soit positionné sur un élément de support (23) de la bague-entretoise (8).

13. Procédé selon la revendication 12,
dans lequel l'élément de connexion de grille (6) comprend une pluralité de doigts (7) et l'élément de support (23) comprend une première partie (24) et une deuxième partie (25), dans lequel la bague-entretoise (8) est tournée jusqu'à ce que les doigts (7) soient positionnés sur les premières parties (24) et une rotation supplémentaire est bloquée par la deuxième partie (25).

14. Procédé selon la revendication 13,
dans lequel l'assemblage du système de pression (7) comprend l'insertion de broches (21) du système de pression (7) dans des fentes (26) de la bague-entretoise (8).

15. Procédé selon l'une quelconque des revendications 11 à 14,
dans lequel l'élément de connexion de grille (6) comprend une pluralité de doigts (27), dans lequel les doigts (27) sont courbés pour être positionnés sur les tiges faisant ressort (12).
